# EUROPEAN PATENT SPECIFICATION

(11) **EP 3 688 819 B1**
(45) Date of publication and mention of the grant of the patent: **29.12.2021**
(21) Application number: 18812323.6
(22) Date of filing: 24.09.2018
(51) Int. Cl.: H01L 31/0224, H01L 31/0236, H01L 31/074

(54) **SOLAR CELLS WITH TRANSPARENT CONTACTS BASED ON POLY-SILICON-OXIDE**
SOLARZELLEN MIT TRANSPARENTEN KONTAKTEN AUF BASIS VON POLYSILICIUMOXID
CELLULES SOLAIRES À CONTACTS TRANSPARENTS À BASE D'OXYDE DE POLYSILICIUM

(30) Priority: 27.09.2017 NL 2019634
(43) Date of publication of application: 05.08.2020
(73) Proprietor: Technische Universiteit Delft, 2628 CN Delft (NL)
(72) Inventor: ISABELLA, Olindo, 2600 AA Delft (NL); PROCEL MOYA, Paul Alejandro, 2600 AA Delft (NL); ZEMAN, Miroslav, 2600 AA Delft (NL); YANG, Guangtao, 2600 AA Delft (NL)
(74) Representative: Vogels, Leonard Johan Paul
(86) International application number: PCT/NL2018/050631
(87) International publication number: WO 2019/066648

(56) References cited:
- WO-A1-2013/180653
- WO-A2-2016/068711
- STUCKELBERGER JOSUA ET AL: "Passivating electron contact based on highly crystalline nanostructured silicon oxide layers for silicon solar cells", SOLAR ENERGY MATERIALS AND SOLAR CELLS, ELSEVIER SCIENCE PUBLISHERS, AMSTERDAM, NL, vol. 158, 9 July 2016 (2016-07-09), pages 2-10, XP029757048, ISSN: 0927-0248, DOI: 10.1016/J.SOLMAT.2016.06.040 cited in the application

## Description

### FIELD OF THE INVENTION

The present invention is in the field of a process for making solar cells, or photovoltaic (PV) cell, with transparent contacts based on poly-silicon-oxide, and solar cells with transparent contacts based on poly-silicon-oxide. Said solar cells comprise at least one hetero junction and typically two hetero junctions.

### BACKGROUND OF THE INVENTION

A solar cell, or photovoltaic (PV) cell, is an electrical device that converts energy of light, typically sun light (hence "solar"), directly into electricity by the so-called photovoltaic effect. The solar cell may be considered a photoelectric cell, having electrical characteristics, such as current, voltage, resistance, and fill factor, which vary when exposed to light and which vary from type of cell to type.

Solar cells are described as being photovoltaic irrespective of whether the source is sunlight or an artificial light. They may also be used as photo detector.

When a solar cell absorbs light it may generate either electron-hole pairs or excitons. In order to obtain an electrical current charge carriers of opposite types are separated. The separated charge carriers are "extracted" to an external circuit, typically providing a DC-current. For practical use a DC-current may be transformed into an AC-current, e.g. by using a transformer.

Typically solar cells are grouped into an array of elements. Various elements may form a panel, and various panels may form a system.

Wafer based c-Si solar cells contribute to more than 90% of the total PV market. According to recent predictions, this trend will remain for the upcoming years towards 2020 and many years beyond. Due to their simplified process, conventional c-Si solar cells dominate a large part of the market. As alternative to the industry to improve the power to cost ratio, the silicon heterojunction approach has become increasingly attractive for PV industry, even though the relatively complicated process to deploy the proper front layers, such as a thermal conductive oxide (TCO) and an inherent low thermal budget of the cells limiting usage of existing production lines and thus result in a negligible market share so far. A heterojunction is the interface that occurs between two layers or regions of dissimilar crystalline semiconductors. These semiconducting materials have unequal band gaps as opposed to a homojunction. A homojunction relates to a semiconductor interface formed by typically two layers of similar semiconductor material, wherein these semiconductor materials have equal band gaps and typically have a different doping (either in concentration, in type, or both). A common example is a homojunction at the interface between an n-type layer and a p-type layer, which is referred to as a p-n junction. In hetereojunctions advanced techniques are used to precisely control a deposition thickness of layers involved and to create a lattice-matched abrupt interface. Three types of heterojunctions can be distinguished, a straddling gap, a staggered gap, and a broken gap.

A disadvantage of solar cells is that the conversion per se is not very efficient, typically, for Si-solar cells, limited to some 20%. Theoretically a single p-n junction crystalline silicon device has a maximum power efficiency of 33.7%. An infinite number of layers may reach a maximum power efficiency of 86%. The highest ratio achieved for a solar cell per se at present is about 44%. For commercial silicon solar cells the record is about 25.6%. In view of efficiency the front contacts may be moved to a rear or back side, eliminating shaded areas. In addition thin silicon films were applied to the wafer. Solar cells also suffer from various imperfections, such as recombination losses, reflectance losses, heating during use, thermodynamic losses, shadow, internal resistance, such as shunt and series resistance, leakage, etc. A qualification of performance of a solar cell is the fill factor (FF). The fill factor may be defined as a ratio of an actual maximum obtainable power to the product of the open circuit voltage and short circuit current. It is considered to be a key parameter in evaluating performance. A typical advanced commercial solar cell has a fill factor > 0.75, whereas less advanced cells have a fill factor between 0.4 and 0.7. Cells with a high fill factor typically have a low equivalent series resistance and a high equivalent shunt resistance; in other words less internal losses occur. Efficiency is nevertheless improving gradually, so every relatively small improvement is welcomed and of significant importance.

Some recent developments are discussed below.

EP 2 797 124 A1 recites a solar cell that includes a semiconductor substrate, a tunneling layer on one surface of the semiconductor substrate, a first conductive type area on the tunneling layer, a second conductive type area on the tunneling layer such that the second conductive type area is separated from the first conductive type area, and a barrier area interposed between the first conductive type area and the second conductive type area such that the barrier area separates the first conductive type area from the second conductive type area.

US2014/166095 A1 recites an all back contact solar cell has a hybrid emitter design. The solar cell has a thin dielectric layer formed on a backside surface of a single crystalline silicon substrate. It has a specifically designed emitter which is made of doped polycrystalline silicon that is formed on the thin dielectric layer. Doping is diffusion based and hence typically requires an extra high temperature step of more than 30 minutes, typically more than 60 minutes. A disadvantage of thermally assisted diffusion of dopants is that dopants enter a silicon bulk material.

WO2013/172056 A1 recites an n-type semiconductor layer and a p-type semiconductor layer, a collector electrode that is formed on the n-type semiconductor layer, and a collector electrode that is formed on the p-type semiconductor layer on a light receiving surface of an n-type crystalline silicon substrate and a rear surface on the opposite side, and an n-type semiconductor area on a surface on the light receiving surface side of the n-type crystalline silicon substrate. Stuckelberger et al. in "Passivating electron contact based on highly crystalline nanostructured silicon oxide layers for silicon solar cells", Solar Energy Materials & Solar Cells, 158 (2016) 2-10, recite a novel passivating contact structure based on a nanostructured silicon-based layer comprising a nanocrystalline silicon oxide (nc-SiOx) layer and a nanocrystalline Si layer. The doping profile over the boundary of the two layers is continuous. The resulting solar cell provides poor efficiencies. WO 2016/068711 A2 recites a process for making back side contacted wafer-based solar cells with in-situ doped crystallized thin-film silicon oxide regions and optionally in-situ doped silicon regions, and back side contacted solar cells. A solar cell, or photovoltaic (PV) cell, is an electrical device that converts energy of light, typically sun light (hence "solar"), directly into electricity by the so-called photovoltaic effect. The solar cell may be considered a photoelectric cell, having electrical characteristics, such as current, voltage, resistance, and fill factor, which vary when exposed to light and which vary from type of cell to type. WO 2013/180653 A1 recites a method of fabricating a hybrid homojunction/heterojunction solar cell. The method includes providing an absorber layer for generating excess charge carriers of opposed polarity from light incident on a first side of the absorber layer; forming a homojunction contact on the first side of the absorber layer for extracting generated excess charge carrier of a first polarity; forming a passivation layer on a second side of the absorber layer, the second side being opposite to the first side, and the passivation layer exhibiting a surface charge of positive or negative polarity for driving the second side of the absorber layer into charge carrier accumulation or into charge carrier inversion; and forming a doped heterojunction contact on the second side of the absorber layer over the passivation layer for extracting generated excess charge carrier of a second polarity, the second polarity being opposite to the first polarity, and the doped heterojunction contact being of opposite polarity to the polarity of the surface charge of the passivation layer, wherein the step of forming the doped heterojunction contact comprises forming one or more contact openings in the passivation layer, and depositing a doped heterojunction layer over the passivation layer, the doped heterojunction layer including one or more heterojunction protruding contacts formed within respective said one or more contact openings.

At present a solar cell having a full area front passivating contact is not attractive, such as due to highly absorptive materials used to build such a structure. That is the case of heavily doped poly-silicon and a-Si layers. In a poly-silicon case, the process requires a very thin polysilicon film for minimizing parasitic absorption loss, and in case of α-Si, the process requires e.g. an extra transparent conductive oxide (TCO) layer for supporting the carrier lateral transport.

The present invention relates to an increased efficiency hetero junction solar cell and various aspects thereof and a simplified process for manufacturing the solar cell which overcomes one or more of the above disadvantages, without jeopardizing functionality and advantages.

### SUMMARY OF THE INVENTION

The present invention relates in a first aspect to a front and rear contacted solar cell according to claim 1, and in a second aspect to a process for making such a solar cell according to claim 17.

The present solar cells have as advantages e.g. an increased conversion efficiency, improved transparency, good carrier collection, low parasitic absorption, a not very complex structure, a high Voc, a high Jsc, a high fill factor, and good passivation especially of the contacts.

The present solar cells are a powerful alternative to improve power to cost ratio. They are competitive to conventional and bifacial single hetero junction solar cells. The present poly-SiOx layers provide a sufficient carrier mobility for lateral carrier transport, good passivation and a low parasitic absorption. Also the solar cell fabrication process is costly and high conversion efficiencies are achieved.

The present invention involves use of poly-Silicon oxide alloys (poly-SiOx) in high efficiency solar cells in the role of carrier-selective passivating contacts. It is an advantage that poly-SiOx has a good transparency and carrier selectivity which is suited for conventional and bi-facial solar cells. In the solar cell passivating contacts can be done by applying a thin layer of passivating film in double or single side textured Si wafer absorber. Then, the doped poly-SiOx layers are deposited. Subsequently typically a metallization step is applied to finish the solar cells. The present contact stack preferably includes a chemical passivating layer (for example, but not limited to, SiO₂), a doped poly-SiOx film, and full or partial metal contact with industrial feasible methods. A high quality passivation of the contact stack has been obtained. To ensure the carrier collection, an additional lowly-doped region is deployed in the absorber bulk, near the c-Si/poly-SiOx interface. The present invention relates generally to conventional and bifacial solar cells, based on n-type and p-type c-Si bulk for both front and rear junctions, and more particularly but not exclusively to crystalline silicon based solar cells.

The present invention makes use of various techniques in order to solve one or more of the prior art problems and provides further advantages; these advantages relate to measurable characteristics (effects) of the obtained devices and hence constitute noticeable physical differences over e.g. the prior art. For instance use is made of doped polycrystalline silicon oxide layers such as deposited by PECVD. It has been found that such results in a minimized surface recombination velocity and enhances lateral transport (e.g. at the front side). The obtained doping profiles are better compared to diffusion stimulated doping profiles, e.g. in terms of an almost spatially constant concentration (dopants/cm³) in the PECVD layer. In addition, as no annealing step is required to diffuse dopants, these dopants do not diffuse to e.g. a silicon substrate. Therefore in case of further solar cell processing especially in view of recrystallization of microcrystalline material a lower thermal annealing temperature (T < 900 °C, typically < 800 °C, and often < 700 °C)) and relatively short process times of 1-30 min, such as 2-20 min, and typically 5-10 min, or in an alternative even no annealing step is required. The thermal budget for the annealing step is therefore limited.

A high efficiency solar cell (> 22% efficiency) is provided. With some simple optimization steps an efficiency of 25-26% is feasible. The present layout can also be used for a so-called 4-terminal solar cell and is thus relatively versatile. The present solar cell may be referred to as a high temperature silicon oxide hetero junction (HT-SOHO).

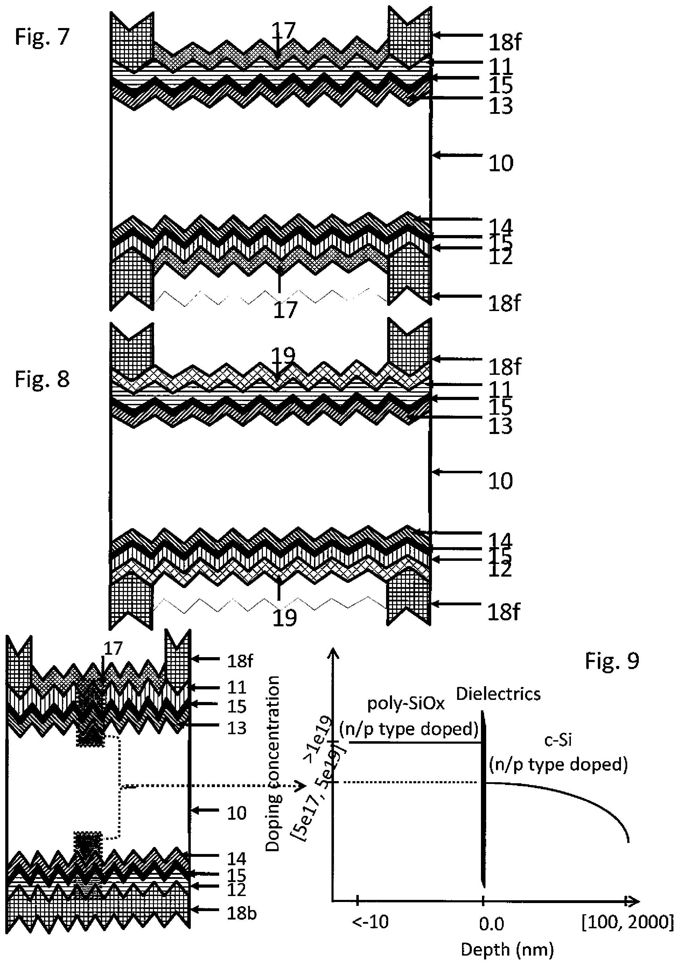

In the present solar cells front and rear (also indicated as back) contacts are present. The present solar cell comprise at least one hetero junction and typically two hetero junctions. The heterojunctions are typically of staggered type. The contacts comprise a stack of layers, which stack comprises n-doped or p-doped poly SiOx layer 11,12 of more than 10 nm thickness, a n-doped or p-doped crystalline Si layer 13,14 typically of 100 nm-5000 nm thickness, wherein the poly SiOx and crystalline Si layer are both p-doped or are both n-doped, and in between said layers a dielectric barrier layer 15 of very small or negligible thickness, e.g. from a monolayer thickness to a thickness of 2.5 nm maximum, wherein said layers cover one and another, that is substantially overlap (90-100%) and typically fully overlap. Typically only a part of the crystalline Si layer 13,14 is doped, such as an upper c.q. lower region. The ratio of doping of poly SiOx:crystalline Si at the dielectric barrier layer 15 is > 2, preferably > 5, more preferably > 10, even more preferably > 10². An exemplary doping profile can be seen in figure 9. The lowly doped region inside the c-Si, near the c-Si/poly-SiOx interface, provide an improved transport of carriers and a high fill factor. So a polycrystalline layer is provided on a very thin dielectric layer, which dielectric layer is provided on a crystalline silicon layer. The dielectric layer provides tunnelling of charges (electrons or holes, respectively), may comprise pinholes, and is considered to act as a barrier for dopants.

The above and other improvements quenches the series resistance of doped regions and the leakage current between them making the shunt resistance very high leading to a high pseudo fill factor of >0.75. In a first exemplary embodiment solar cells with a conversion efficiency of 20.2 % have been fabricated; improving various aspects of the process and specifically various steps thereof a conversion efficiency of 22-23 % or more is found to be achievable. Such relates to an improvement of 1-3% over prior art devices, which is a relative improvement of 5-15%. For return of investment such a difference is considered huge.

With respect to prior art solar cells fabricated via diffusion, the present invention involves the use of doping techniques which can either accurately provide a required doping profile or overcome technical limitations of a diffusion process. In fact, in case of standard doping diffusion, the doping profile is found to be limited by the solid solubility of the dopants in silicon, hence can not be optimized fully. The combination of e.g. ion implanted phosphorous and epitaxial grown of Si doped in situ with e.g. boron enables the use of a low temperature annealing step. In addition, by using single-side doping techniques, the doping profile of each doped layer can be separately optimized. A disadvantage the present invention is that an additional doping is required with respect to a prior art process.

The present process is considered to be relatively simple. In particular, fabrication tools thereof are already part of standard production lines. Therefore the present invention may be considered commercially available from the start since it does not require development of additional process tools.

In summary the present invention provides a simplified fabrication process wherein solar cell precursors can be finished within a couple of steps, and which is a low cost and high throughput process, using compatible industrial standard metallization steps, solar cells featuring a high Voc due to the full passivated contacts, solar cells featuring a high Jsc & Voc due to the high transparency of the passivating contacts, solar cells featuring a relatively high fill factor (FF) due to the lowly doped c-Si regions near the interfaces, and wherein the design is applicable to both a front/rear contacted conventional solar cell architecture, a bifacial solar cell architecture and for both n-type and p-type bulk material.

Thereby the present invention provides a solution to one or more of the above mentioned problems.

Advantages of the present description are detailed throughout the description. References to the figures are not limiting, and are only intended to guide the person skilled in the art through details of the present invention.

### DETAILED DESCRIPTION OF THE INVENTION

The present invention relates in a first aspect to front and rear contacted solar cell according to claim 1, and in a second aspect to a process for making such a solar cell according to claim 16.

In an exemplary embodiment of the present solar cell the contact stack is a carrier selective passivating contact. Therewith good transport of charge carriers is obtained.

In an exemplary embodiment of the present solar cell the contact stack is transparent, such as > 90% @ 490 nm, preferably > 95%.

In an exemplary embodiment the present solar cell comprises a single sided or double sided textured substrate 10, typically a crystalline Si substrate, such as a microscale texture, a nanoscale texture, and combinations thereof. Therewith an improved efficiency is obtained.

In an exemplary embodiment the present solar cell comprises a 5*10¹⁴-0.5*10¹⁹ dopants/cm³ n- or p-type doped crystalline Si layer 13,14, preferably 5*10¹⁵-1*10¹⁸ dopants/cm³, more preferably 2*10¹⁶-5*10¹⁷ dopants/cm³, such as preferably 5*10¹⁶-1*10¹⁷ dopants/cm³, wherein a doping concentration is preferably spatially constant, wherein n-type dopants are selected from P, As, Bi, Sb and Li, wherein p-type dopants are selected from B, Ga, and In. The dopants are found to contribute to the advantages of the invention.

In an exemplary embodiment the present solar cell comprises a dielectric passivation layer or dielectric passivation stack 17 on the cell. Typically a passivation stack is provided for protecting the cells against environmental influences.

In an exemplary embodiment the present solar cell comprises a 10¹⁴-10¹⁷ dopants/cm³ n- or p-type doped substrate, typically Si, preferably 10¹⁵-10¹⁶ dopants/cm³.

In an exemplary embodiment the present solar cell comprises at least one of a metal layer on a back side 18b, metal contacts on a front side 18f and/or on a back side, a transparent conductive layer 19, such as an oxide layer. The metal contacts are used to connect the solar cells, such as to a grid, to a storage unit, such as a battery, to a DC/AC converter, etc.

In an exemplary embodiment the present solar cell comprises at least one dielectric barrier layer 15 each independently of thickness of 0.1 nm-1.4 nm, preferably 0.15 nm-1.2 nm, more preferably 0.2 nm-1.0 nm, even more preferably 0.25 nm-0.8 nm, such as 0.4 nm-0.5 nm, wherein the dielectric barrier layer 15 independently comprises at least one material selected from SiO₂, HfO₂, and W₂O₅. The barrier layer is preferably as thin as possible.

In an exemplary embodiment of the present solar cell the material of the transparent conductive layer 19is selected from ITO, IOH, ZnO or doped ZnO, IWO, and/or wherein a thickness of the transparent conductive layer < 100 nm, and/or wherein the refractive index < 2.2, preferably < 2, such as < 1.5. The refractive index is preferably close to air in terms of efficiency.

In an exemplary embodiment of the present solar cell in the stack of layers, the n-doped or p-doped poly SiOx layer (11,12), the n-doped or p-doped crystalline Si layer (13,14), and the dielectric barrier layer (15) are each independently in full contact with one and another over an area of >50% of a surface of the largest of two contacting surfaces, preferably >90%, more preferably >95%, even more preferably >98%, such as >99%. In other words the layers in the stack of layers are in contact with one and another and no further layers are provided in between.

Various exemplary embodiments of the present solar cell are detailed below.

Solar cell A comprises a stack of a metal layer 18b, an n-type doped poly-SiOx layer 12, a dielectric layer 15, an n-type-doped crystalline Si-layer 14, a Si-substrate 10, a p-type-doped crystalline Si-layer 13, a dielectric layer 15, a p-type doped poly-SiOx layer 11, a dielectric layer 17, and metal contacts 18f penetrating through the dielectric layer 17 and contacting the p-type doped poly-SiOx layer 11.

Solar cell B comprises a stack of a metal layer 18b, a p-type doped poly-SiOx layer 12, a dielectric layer 15, a p-type-doped crystalline Si-layer 14, a Si-substrate 10, an n-type-doped crystalline Si-layer 13, a dielectric layer 15, an n-type doped poly-SiOx layer 11, a dielectric layer 17, and metal contacts 18f penetrating through the dielectric layer 17 and contacting the n-type doped poly-SiOx layer 11.

Solar cell C comprises a stack of a metal layer 18b, an n-type doped poly-SiOx layer 12, a dielectric layer 15, an n-type-doped crystalline Si-layer 14, a Si-substrate 10, a p-type-doped crystalline Si-layer 13, a dielectric layer 15, a p-type doped poly-SiOx layer 11, a transparent conductive oxide layer 19, and metal contacts 18f penetrating through the transparent conductive oxide layer 19 and contacting the p-type doped poly-SiOx layer 11.

Solar cell D comprises a stack of a metal layer 18b, a p-type doped poly-SiOx layer 12, a dielectric layer 15, a p-type-doped crystalline Si-layer 14, a Si-substrate 10, an n-type-doped crystalline Si-layer 13, a dielectric layer 15, an n-type doped poly-SiOx layer 11, a transparent conductive oxide layer 19, and metal contacts 18f penetrating through the transparent conductive oxide layer 19 and contacting the n-type doped poly-SiOx layer 11.

Solar cell E comprises a stack of a metal layer 18b, a transparent conductive oxide layer 19, an n-type doped poly-SiOx layer 12, a dielectric layer 15, an n-type-doped crystalline Si-layer 14, a Si-substrate 10, a p-type-doped crystalline Si-layer 13, a dielectric layer 15, a p-type doped poly-SiOx layer 11, a transparent conductive oxide layer 19, and metal contacts 18f penetrating through the transparent conductive oxide layer 19 and contacting the p-type doped poly-SiOx layer 11.

Solar cell F comprises a stack of a metal layer 18b, a transparent conductive oxide layer 19, a p-type doped poly-SiOx layer 12, a dielectric layer 15, a p-type-doped crystalline Si-layer 14, a Si-substrate 10, an n-type-doped crystalline Si-layer 13, a dielectric layer 15, an n-type doped poly-SiOx layer 11, a transparent conductive oxide layer 19, and metal contacts 18f penetrating through the transparent conductive oxide layer 19 and contacting the n-type doped poly-SiOx layer 11.

Solar cell G comprises a stack of a dielectric layer 17, metal contacts 18b penetrating through the dielectric layer 17 and contacting an n-type doped poly-SiOx layer 12, the n-type doped poly-SiOx layer 12, a dielectric layer 15, an n-type-doped crystalline Si-layer 14, a Si-substrate 10, a p-type-doped crystalline Si-layer 13, a dielectric layer 15, a p-type doped poly-SiOx layer 11, a dielectric layer 17, and metal contacts 18f penetrating through the dielectric layer 17 and contacting the p-type doped poly-SiOx layer 11.

Solar cell H comprises a stack of a dielectric layer 17, metal contacts 18b penetrating through the dielectric layer 17 and contacting an p-type doped poly-SiOx layer 12, the p-type doped poly-SiOx layer 12, a dielectric layer 15, a p-type-doped crystalline Si-layer 14, a Si-substrate 10, an n-type-doped crystalline Si-layer 13, a dielectric layer 15, an n-type doped poly-SiOx layer 11, a dielectric layer 17, and metal contacts 18f penetrating through the dielectric layer 17 and contacting the n-type doped poly-SiOx layer 11.

The above types of solar cell are indicative of the versatile design of the present invention.

In an exemplary embodiment the present solar cell comprises at least one textured surface 20, wherein the textured surface 20 has an aspect ratio (height:depth of a textured structure) of 2-10, preferably 5-8. A textured surface is found to increase the efficiency of the solar cell.

In an exemplary embodiment of the present solar cell having n-doped or p-doped poly SiOx layer 11,12 independently of 10 nm- 5000 nm thickness, preferably of 20 nm-2000 nm thickness, more preferably of 50 nm-1000 nm thickness, such as 100 nm- 250 nm thickness, and comprising 1*10¹⁹-5*10²² n- or p-type dopants/cm³, preferably 2*10¹⁹-1*10²² dopants/cm³, more preferably 3*10¹⁹-1*10²¹ dopants/cm³, even more preferably 5*10¹⁹-5*10²⁰ dopants/cm³, such as 7*10¹⁹-1*10²⁰ dopants/cm³, wherein a doping profile is preferably substantially constant over the thickness of the layer, i.e. spatially constant varying less than 2% relative, wherein n-type dopants are selected from P, As, Bi, Sb and Li, wherein p-type dopants are selected from B, Ga, and In. Doping may be performed by ion-implantation or by in-situ doping.

In an exemplary embodiment the present solar cell comprises at least one dielectric layer (17) each independently of thickness of 10 nm-2000 nm, preferably 50 nm-1000 nm, more preferably 100 nm-500 nm, even more preferably 200 nm-400 nm, such as 250 nm-300 nm, wherein the dielectric layer or stack of layers 17 independently comprises at least one material selected from SiNx, AlOx, a n-type or p-type doped or un-doped transparent conductive oxide, such as Indium Titanium Oxide, doped ZnO, Indium tungsten Oxide, Indium Tin Oxide, Indium Zinc Oxide, and Aluminium Zinc Oxide.

In an exemplary embodiment of the present solar cell the metal of the metal layers or metal contacts 18b and metal layers or metal contacts 18f independently comprises at least one of Cu, Al, W, Ti, Ni, and wherein a thickness of the metal layers or metal contacts is 200-5000 nm, preferably 300-3000 nm, such as 500-1000 nm.

In a second aspect the present invention relates to a method of producing a solar cell according to the invention comprising at least one of providing a silicon substrate 10, texturing a rear and/or substrate surface 10, doping a front side 13,14, doping a rear side 13,14, annealing said doped sides 13,14 at a temperature of less than 1000 °C during a sufficient period of time, providing a 0<tdiel 2.5 nm thick dielectric layer 15 on the doped front side and/or doped rear side, providing n-doped or p-doped poly SiOx layer 11,12 of > 10 nm thickness on the dielectric layer 15, wherein the ratio of doping of poly SiOx:crystalline Si at the dielectric barrier layer is > 2, providing at least one dielectric layer 17 on the poly SiOx layer 11,12, and providing a metal layer 18b and/or metal contacts 18f at a rear and back side being in electrical contact with the n-doped or p-doped poly SiOx layer 11,12, respectively.

In an exemplary embodiment of the present method the n-doped or p-doped poly SiOx layer 11,12 is provided by PECVD, or LPCVD, wherein dopants are constantly provided during deposition.

In an exemplary embodiment of the present method metal contacts and/or metal layers 18b,18f are provided by metal deposition and lift off (of non-contact areas), screen printing, and electrical plating.

In an exemplary embodiment of the present method dopants in the poly SiOx layer are activated.

The invention is further detailed by the accompanying figures and examples, which are exemplary and explanatory of nature and are not limiting the scope of the invention. To the person skilled in the art it may be clear that many variants, being obvious or not, may be conceivable falling within the scope of protection, defined by the present claims.

### SUMMARY OF FIGURES

Figures 1-8 show a schematic representation of an example of the present solar cell.

Figure 9 shows a doping profile.

### DETAILED DESCRIPTION OF FIGURES

- 10: substrate
- 11: p-doped poly silicon oxide
- 12: n-doped poly silicon oxide
- 13: p-doped crystalline silicon
- 14: n-doped crystalline silicon
- 15: thin dielectric layer
- 17: dielectric layer or stack of layers
- 18b: back side metal contacts or back side metal layer
- 18f: front side metal contacts or front side metal layer
- 19: transparent conductive oxide layer
- 20: textured surface

The figures are further detailed in the description of the experiments below.

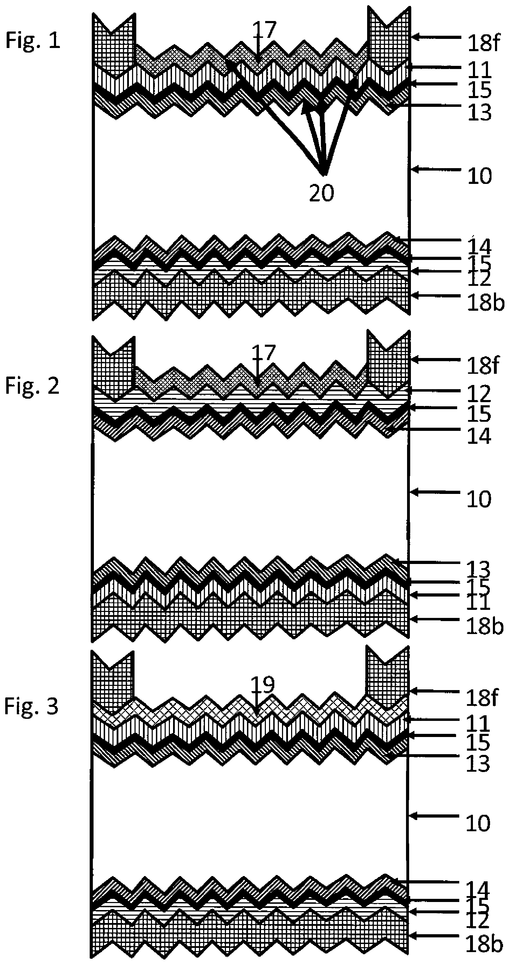

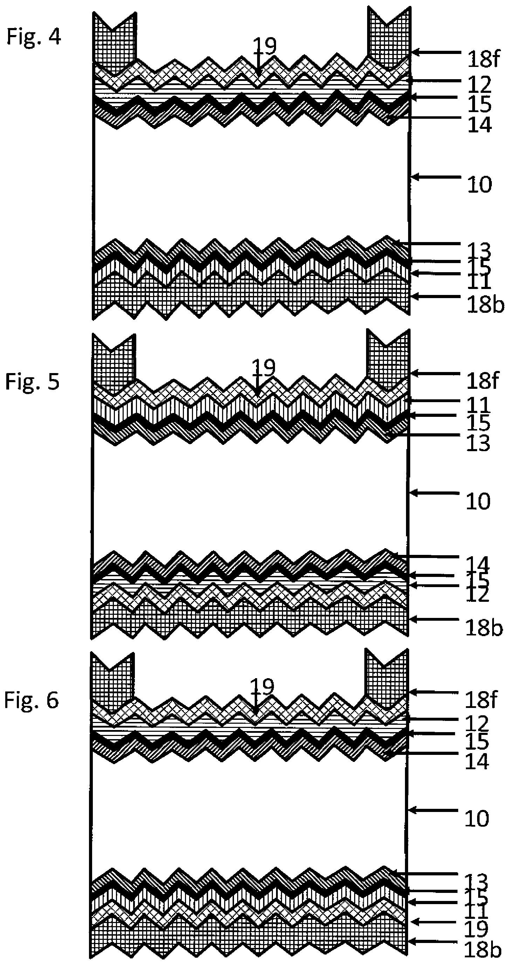

In figures 1-6 shows front and rear contacted solar cells, indicated with type A-F. Therein a substrate 10, typically n-or p-doped silicon is provided. The substrate may be textured on one or both sides. On the substrate low p-doped crystalline silicon 13 and/or low n-doped crystalline silicon 14 may be provided. The low doped crystalline silicon layer 13,14 is covered by a thin dielectric layer 15. The thin dielectric layer is provided with a high p-doped poly silicon oxide 11 layer or a high n-doped poly silicon oxide 12, respectively. Than metal contacts or metal layers 18 are provided on the back (18b) and on the front (18f). In addition a dielectric layer or stack of layers 17, typically for passivation, and optionally at least one transparent conductive oxide layer 19 may be provided.

Figures 7-8 show similar designs as above for a bifacial solar cell.

Figure 9 shows schematics of the present solar cell (left) and doping profile over the dielectric layer 15 (right). The poly crystalline SiOx is relatively highly dope and spatially constant doped, of either n- or p-type, the dielectric layer is undoped, whereas the exemplary crystalline silicon layer is relatively low n- or p-type doped, wherein a doping concentration may or may not drop with a depth.

### EXAMPLES/EXPERIMENTS

Results of the present solar cells are found to be good. For instance, an excellent surface passivation is achieved. The V_{oc} and fill factor FF of the cells are found to be sensitive to the NAOS-SiO₂ tunneling layer growth process. For the n-type solar cell Jo of 3 fA/cm² and inducing a V_{oc} as high as 740 mV, the p-type solar cell J₀ of 23 fA/cm² and inducing a V_{oc} as high as 700 mV, is obtained. The best solar cell presents an efficiency of 20%, a FF up to 83.5%, and Jsc = 33.5 mA/cm² with a double side flat surface, after texturing the surface a Jsc above 40.7 mA/cm² are easily achieved.

The invention although described in detailed explanatory context may be best understood in conjunction with the accompanying figures.

## Claims

1. Front and rear contacted solar cell comprising
at least one hetero junction,
front and back contacts (18b,18f), wherein at least one contact comprises a stack of layers, which stack comprises an n-doped or p-doped poly SiOx layer (11,12) of > 10 nm thickness, a n-doped or p-doped crystalline Si layer (13,14) of 100 nm-5000 nm thickness, wherein the poly SiOx layer (11,12) and crystalline Si layer (13,14) are both p-doped or are both n-doped, and in between said layers a dielectric barrier layer (15) of thickness of 0 < t_{diel}<2.5 nm, wherein said layers cover one and another, **characterized in that**
the ratio of doping of poly SiOx:crystalline Si at the dielectric barrier layer is > 2, preferably > 5, more preferably > 10, even more preferably > 10².

2. Solar cell according to claim 1, wherein the contact stack (18b,18f) is a carrier selective passivating contact, and/or wherein the contact stack (18b,18f) is transparent.

3. Solar cell according to any of claims 1-2, comprising a single sided or double sided textured substrate (10), and/or comprising a 5*10¹⁴-0.5*10¹⁹ dopants/cm³ n- or p-type doped crystalline Si layer (13,14), wherein a doping concentration is preferably spatially constant,
wherein n-type dopants are selected from P, As, Bi, Sb and Li, and wherein p-type dopants are selected from B, Ga, and In.

4. Solar cell according to any of claims 1-3, comprising a dielectric passivation layer or dielectric passivation stack (17) on the cell, and/or
comprising a 10¹⁴-10¹⁷ dopants/cm³ n- or p-type doped substrate (10) .

5. Solar cell according to any of claims 1-4, comprising at least one of a metal layer on a back side (18b), metal contacts on a front side (18f) and/or on a back side (18b), and a transparent conductive layer (19).

6. Solar cell according to any of claims 1-5, comprising at least one dielectric barrier layer (15) each independently of thickness of 0.1 nm-1.4 nm,
wherein the dielectric barrier layer (15) independently comprises at least one material selected from SiO₂, HfO₂, and W₂O₅.

7. Solar cell according to any of claims 1-6, wherein the material of the transparent conductive layer (19)is selected from ITC, IOH, ZnO or doped ZnO, and IWO, and/or wherein a thickness of the transparent conductive layer (19) is <100 nm, and/or wherein the refractive index is <2.2.

8. Solar cell according to any of claims 1-7, wherein in the stack of layers, the n-doped or p-doped poly SiOx layer (11,12), the n-doped or p-doped crystalline Si layer (13,14), and the dielectric barrier layer (15) are each independently in full contact with one and another over an area of >50% of a surface of the largest of two contacting surfaces.

9. Solar cell according to any of claims 1-8,
(A) comprising a stack of a metal layer (18b), an n-type doped poly-SiOx layer (12), a dielectric layer (15), an n-type-doped crystalline Si-layer (14), a Si-substrate (10), a p-type-doped crystalline Si-layer (13), a dielectric layer (15), a p-type doped poly-SiOx layer (11), a dielectric layer (17), and metal contacts (18f) penetrating through the dielectric layer (17) and contacting the p-type doped poly-SiOx layer (11), or
(B) comprising a stack of a metal layer (18b), a p-type doped poly-SiOx layer (12), a dielectric layer (15), a p-type-doped crystalline Si-layer (14), a Si-substrate (10), an n-type-doped crystalline Si-layer (13), a dielectric layer (15), an n-type doped poly-SiOx layer (11), a dielectric layer (17), and metal contacts (18f) penetrating through the dielectric layer (17) and contacting the n-type doped poly-SiOx layer (11), or
(C) comprising a stack of a metal layer (18b), an n-type doped poly-SiOx layer (12), a dielectric layer (15), an n-type-doped crystalline Si-layer (14), a Si-substrate (10), a p-type-doped crystalline Si-layer (13), a dielectric layer (15), a p-type doped poly-SiOx layer (11), a transparent conductive oxide layer (19), and metal contacts (18f) penetrating through the transparent conductive oxide layer (19) and contacting the p-type doped poly-SiOx layer (11), or
(D) comprising a stack of a metal layer (18b), a p-type doped poly-SiOx layer (12), a dielectric layer (15), a p-type-doped crystalline Si-layer (14), a Si-substrate (10), an n-type-doped crystalline Si-layer (13), a dielectric layer (15), an n-type doped poly-SiOx layer (11), a transparent conductive oxide layer (19), and metal contacts (18f) penetrating through the transparent conductive oxide layer (19) and contacting the n-type doped poly-SiOx layer (11), or
(E) comprising a stack of a metal layer (18b), a transparent conductive oxide layer (19), an n-type doped poly-SiOx layer (12), a dielectric layer (15), an n-type-doped crystalline Si-layer (14), a Si-substrate (10), a p-type-doped crystalline Si-layer (13), a dielectric layer (15), a p-type doped poly-SiOx layer (11), a transparent conductive oxide layer (19), and metal contacts (18f) penetrating through the transparent conductive oxide layer (19) and contacting the p-type doped poly-SiOx layer (11), or
(F) comprising a stack of a metal layer (18b), a transparent conductive oxide layer (19), a p-type doped poly-SiOx layer (12), a dielectric layer (15), a p-type-doped crystalline Si-layer (14), a Si-substrate (10), an n-type-doped crystalline Si-layer (13), a dielectric layer (15), an n-type doped poly-SiOx layer (11), a transparent conductive oxide layer (19), and metal contacts (18f) penetrating through the transparent conductive oxide layer (19) and contacting the n-type doped poly-SiOx layer (11), or
(G) comprising a stack of a dielectric layer (17), metal contacts (18b) penetrating through the dielectric layer (17) and contacting an n-type doped poly-SiOx layer (12), an n-type doped poly-SiOx layer (12), a dielectric layer (15), an n-type-doped crystalline Si-layer (14), a Si-substrate (10), a p-type-doped crystalline Si-layer (13), a dielectric layer (15), a p-type doped poly-SiOx layer (11), a dielectric layer (17), and metal contacts (18f) penetrating through the dielectric layer (17) and contacting the p-type doped poly-SiOx layer (11), or
(H) comprising a stack of a dielectric layer (17), metal contacts (18b) penetrating through the dielectric layer (17) and contacting an p-type doped poly-SiOx layer (12), a p-type doped poly-SiOx layer (12), a dielectric layer (15), a p-type-doped crystalline Si-layer (14), a Si-substrate (10), an n-type-doped crystalline Si-layer (13), a dielectric layer (15), an n-type doped poly-SiOx layer (11), a dielectric layer (17), and metal contacts (18f) penetrating through the dielectric layer (17) and contacting the n-type doped poly-SiOx layer (11).

10. Solar cell according to any of claims 1-9, comprising at least one textured surface (20), wherein the textured surface (20) has an aspect ratio (height:depth of a textured structure) of 2-10.

11. Solar cell according to any of claims 1-10, having n-doped or p-doped poly SiOx layer (11,12) independently of 10 nm- 5000 nm thickness, and
comprising 1*10¹⁹-5*10²² n- or p-type dopants/cm³, wherein a doping profile is preferably substantially constant over the thickness of the layer (11,12),
wherein n-type dopants are selected from P, As, Bi, Sb and Li, wherein p-type dopants are selected from B, Ga, and In.

12. Solar cell according to any of claims 1-11, comprising at least one dielectric layer (17) each independently of thickness of 10 nm-2000 nm,
wherein the dielectric layer (17) independently comprises at least one material selected from SiNₓ, AlOₓ, a n-type or p-type doped or un-doped transparent conductive oxide.

13. Solar cell according to any of claims 1-12, wherein the metal of the metal layers (18b) and metal contacts (18f) independently comprises at least one of Cu, Al, W, Ti, Ni, and wherein a thickness of said metal (18b,18f) is 200-5000 nm.

14. Method of producing a solar cell according to any of claims 1-13 comprising at least one of
providing a silicon substrate (10),
texturing a rear and/or front substrate surface (10),
doping a front side (13,14),
doping a rear side (13,14),
annealing said doped sides (13,14) at a temperature of less than 1000 °C during a sufficient period of time,
providing a 0<t_{diel}<2.5 nm thick dielectric layer (15) on the doped front side and/or doped rear side,
providing n-doped or p-doped poly SiOx layer (11,12) of > 10 nm thickness on the dielectric layer (15), wherein the ratio of doping of poly SiOx:crystalline Si at the dielectric barrier layer is > 2,
providing at least one dielectric layer (17) on the poly SiOx layer (11,12),
and providing a metal layer (18b) and/or metal contacts (18f) at a rear and front side being in electrical contact with the n-PCT NL2C18/050631 Claims EP 18812323.6 March 2020 clean doped or p-doped poly SiOx layer (11,12), respectively, preferably
wherein the n-doped or p-doped poly SiOx layer (11,12) is provided by PECVD, or LPCVD, wherein dopants are constantly provided during deposition, preferably
wherein metal contacts and/or metal layers (18b,18f) are provided by metal deposition and lift off of non-contact areas ,
screen printing, and electrical plating, preferably wherein dopants in the poly SiOx layer (11,12) are activated.

## Patentansprüche

1. Vorder- und rückseitig kontaktierte Solarzelle mit
mindestens einen Hetero-Übergang,
Vorderseiten- und Rückseitenkontakten (18b,18f), wobei mindestens ein Kontakt einen Stapel von Schichten umfasst, wobei der Stapel eine n-dotierte oder p-dotierte Poly-SiOₓ-Schicht (11,12) mit einer Dicke von >10 nm, eine n-dotierte oder p-dotierte kristalline Si-Schicht (13,14) mit einer Dicke von 100 nm bis 5000 nm, wobei die Poly-SiOₓ-Schicht (11,12) und die kristalline Si-Schicht (13,14) beide p-dotiert oder beide n-dotiert sind, und zwischen diesen Schichten eine dielektrische Sperrschicht (15) mit einer Dicke von 0<t_{diel}<2.5 nm, wobei die Schichten einander bedecken, wobei das Verhältnis der Dotierung von Poly-Si-Oₓ:kristallinem Si an der dielektrischen Sperrschicht >2, vorzugsweise >5, noch bevorzugter >10, noch bevorzugter >10² ist.

2. Solarzelle nach Anspruch 1, wobei der Kontaktstapel (18b,18f) ein trägerselektiver Passivierungskontakt ist, und/oder wobei der Kontaktstapel (18b,18f) transparent ist.

3. Solarzelle nach einem der Ansprüche 1-3, umfassend ein einseitig oder beidseitig strukturiertes Substrat (10), und/oder mit einer 5*10¹⁴-0,5*10¹⁹ Dotierstoffe/cm³ n- oder p-dotierten kristallinen Si-Schicht (13,14), wobei eine Dotierstoffkonzentration vorzugsweise räumlich konstant ist,
wobei n-Dotierstoffe aus P, As, Bi, Sb und Li ausgewählt sind, und wobei p-Dotierstoffe aus B, Ga und In ausgewählt sind.

4. Solarzelle nach einem der Ansprüche 1 bis 3, umfassend eine di-elektrische Passivierungsschicht oder einen dielektrischen Passivierungsstapel (17) auf der Zelle, und/oder mit einem 10¹⁴-10¹⁷ Dotierstoffe/cm³ n- oder p-dotierten Substrat (10) .

5. Solarzelle nach einem der Ansprüche 1-4, umfassend mindestens eine Metallschicht auf einer Rückseite (18b), Metallkontakte auf einer Vorderseite (18f) und/oder auf einer Rückseite (18b) und eine transparente leitfähige Schicht (19).

6. Solarzelle nach einem der Ansprüche 1 bis 5, mit mindestens einer dielektrischen Sperrschicht (15), die unabhängig voneinander eine Dicke von 0,1 nm bis 1,4 nm aufweist,
wobei die dielektrische Sperrschicht (15) unabhängig voneinander mindestens ein Material umfasst, das aus SiO₂, HfO₂ und W₂O₅ ausgewählt ist.

7. Solarzelle nach einem der Ansprüche 1-6, wobei das Material der transparenten leitfähigen Schicht (19) ausgewählt ist aus ITO, IOH, ZnO oder dotiertem ZnO und IWO, und/oder wobei eine Dicke der transparenten leitfähigen Schicht (19) <100 nm ist, und/oder wobei der Brechungsindex <2,2 ist.

8. Solarzelle nach einem der Ansprüche 1-7, wobei in dem Schichtstapel die n-dotierte oder p-dotierte Poly-SiOₓ-Schicht (11,12), die n-dotierte oder p-dotierte kristalline Si-Schicht (13,14) und die dielektrische Barriereschicht (15) jeweils unabhängig voneinander über einen Bereich von >50% einer Oberfläche der größten der beiden Kontaktflächen in vollem Kontakt miteinander stehen.

9. Solarzelle nach einem der Ansprüche 1-8,
(A) umfassend einen Stapel aus einer Metallschicht (18b), einer n-dotierten Poly-SiOₓ-Schicht (12), einer dielektrischen Schicht (15), einer n-dotierten kristallinen Si-Schicht (14), einem Si-Substrat (10), einer p-dotierten kristallinen Si-Schicht (13), eine dielektrische Schicht (15), eine p-dotierte Poly-SiOₓ-Schicht (11), eine dielektrische Schicht (17) und Metallkontakte (18f), die die dielektrische Schicht (17) durchdringen und die p-dotierte Poly-SiOₓ-Schicht (11) kontaktieren, oder
(B) mit einem Stapel aus einer Metallschicht (18b), einer p-dotierten Poly-SiOₓ-Schicht (12), einer dielektrischen Schicht (15), einer p-dotierten kristallinen Si-Schicht (14), einem Si-Substrat (10), einer n-dotierten kristallinen Si-Schicht (13), eine dielektrische Schicht (15), eine n-dotierte Poly-SiOₓ-Schicht (11), eine dielektrische Schicht (17) und Metallkontakte (18f), die die dielektrische Schicht (17) durchdringen und die n-dotierte Poly-SiOₓ-Schicht (11) kontaktieren, oder
(C) mit einem Stapel aus einer Metallschicht (18b), einer n-dotierten Poly-SiOₓ-Schicht (12), einer dielektrischen Schicht (15), einer n-dotierten kristallinen Si-Schicht (14), einem Si-Substrat (10), einer p-dotierten kristallinen Si-Schicht (13), einer dielektrischen Schicht (15) eine p-dotierte Poly-SiOₓ-Schicht (11), eine transparente leitfähige Oxidschicht (19) und Metallkontakte (18f), die die transparente leitfähige Oxidschicht (19) durchdringen und die p-dotierte Poly-SiOₓ-Schicht (11) kontaktieren, oder
(D) mit einem Stapel aus einer Metallschicht (18b), einer p-dotierten Poly-SiOₓ-Schicht (12), einer dielektrischen Schicht (15), einer p-dotierten kristallinen Si-Schicht (14), einem Si-Substrat (10), einer n-dotierten kristallinen Si-Schicht (13), einer dielektrischen Schicht (15) eine n-dotierte Poly-SiOₓ-Schicht (11), eine transparente leitfähige Oxidschicht (19) und Metallkontakte (18f), die die transparente leitfähige Oxidschicht (19) durchdringen und die n-dotierte Poly-SiOₓ-Schicht (11) kontaktieren, oder
(E) mit einem Stapel aus einer Metallschicht (18b), einer transparenten leitfähigen Oxidschicht (19), einer n-dotierten Poly-SiOₓ-Schicht (12), einer dielektrischen Schicht (15), einer n-dotierten kristallinen Si-Schicht (14), einem Si-Substrat (10), einer p-dotierten kristallinen Si-Schicht (13), eine dielektrische Schicht (15), eine p-dotierte Poly-SiOx-Schicht (11), eine transparente leitfähige Oxidschicht (19) und Metallkontakte (18f), die die transparente leitfähige Oxidschicht (19) durchdringen und die p-dotierte Poly-SiOₓ-Schicht (11) kontaktieren, oder
(F) mit einem Stapel aus einer Metallschicht (18b), einer transparenten leitfähigen Oxidschicht (19), einer p-dotierten Poly-SiOₓ-Schicht (12), einer dielektrischen Schicht (15), einer p-dotierten kristallinen Si-Schicht (14), einem Si-Substrat (10), einer n-dotierten kristallinen Si-Schicht (13) eine dielektrische Schicht (15), eine n-dotierte Poly-SiOₓ-Schicht (11), eine transparente leitende Oxidschicht (19) und Metallkontakte (18f), die die transparente leitende Oxidschicht (19) durchdringen und die n-dotierte Poly-SiOₓ-Schicht (11) kontaktieren, oder
(G) mit einem Stapel aus einer dielektrischen Schicht (17), Metallkontakten (18b), die durch die dielektrische Schicht (17) dringen und eine n-dotierte Poly-SiOx-Schicht (12) kontaktieren, einer n-dotierten Poly-SiOx-Schicht (12), einer dielektrischen Schicht (15), einer n-dotierten kristallinen Si-Schicht (14), ein Si-Substrat (10), eine p-dotierte kristalline Si-Schicht (13), eine dielektrische Schicht (15), eine p-dotierte Poly-SiOₓ-Schicht (11), eine dielektrische Schicht (17) und Metallkontakte (18f), die die dielektrische Schicht (17) durchdringen und die p-dotierte Poly-SiOₓ-Schicht (11) kontaktieren, oder
(H) mit einem Stapel aus einer dielektrischen Schicht (17), Metallkontakten (18b), die die dielektrische Schicht (17) durchdringen und eine p-dotierte Poly-SiOₓ-Schicht (12) kontaktieren, einer p-dotierten Poly-SiOₓ-Schicht (12), einer dielektrischen Schicht (15), einer p-dotierten kristallinen Si-Schicht (14), ein Si-Substrat (10), eine n-dotierte kristalline Si-Schicht (13), eine dielektrische Schicht (15), eine n-dotierte Poly-SiOₓ-Schicht (11), eine dielektrische Schicht (17) und Metallkontakte (18f), die die dielektrische Schicht (17) durchdringen und die n-dotierte Poly-SiOₓ-Schicht (11) kontaktieren.

10. Solarzelle nach einem der Ansprüche 1-9, umfassend mindestens eine texturierte Oberfläche (20), wobei die texturierte Oberfläche (20) ein Seitenverhältnis (Höhe:Tiefe einer texturierten Struktur) von 2-10 aufweist.

11. Solarzelle nach einem der Ansprüche 1-10, mit einer n-dotierten oder p-dotierten Poly-SiOₓ-Schicht (11, 12), die unabhängig voneinander eine Dicke von 10 nm bis 5000 nm aufweist, und die 1*10¹⁹-5*10²² n- oder p-Dotierstoffe/cm³ umfasst, wobei ein Dotierprofil vorzugsweise im Wesentlichen über die Dicke der Schicht (11, 12) konstant ist,
wobei n-Typ-Dotierstoffe aus P, As, Bi, Sb und Li ausgewählt sind,
wobei p-Dotierstoffe aus B, Ga und In ausgewählt sind.

12. Solarzelle nach einem der Ansprüche 1-11, umfassend mindestens eine dielektrische Schicht (17), die jeweils unabhängig voneinander eine Dicke von 10 nm bis 2000 nm aufweist,
wobei die dielektrische Schicht (17) unabhängig voneinander mindestens ein Material umfasst, das aus SiNₓ, AlOₓ, einem n- oder p-dotierten oder nicht-dotierten transparenten leitfähigen Oxid ausgewählt ist.

13. Solarzelle nach einem der Ansprüche 1-12, wobei das Metall der Metallschichten (18b) und der Metallkontakte (18f) unabhängig voneinander mindestens eines der Materialien Cu, Al, W, Ti, Ni umfasst, und
wobei eine Dicke des Metalls (18b,18f) 200-5000 nm beträgt.

14. Verfahren zur Herstellung einer Solarzelle nach einem der Ansprüche 1-13, umfassend mindestens eines der folgenden Verfahren
Bereitstellen eines Siliziumsubstrats (10),
Texturierung einer hinteren und/oder vorderen Substratoberfläche (10) ,
Dotieren einer Vorderseite (13,14),
Dotieren einer Rückseite (13,14),
Tempern der dotierten Seiten (13,14) bei einer Temperatur von weniger als 1000 °C während einer ausreichenden Zeitspanne, Bereitstellen einer 0<t_{diel}<2,5 nm dicken dielektrischen Schicht (15) auf der dotierten Vorderseite und/oder dotierten Rückseite, Bereitstellen einer n-dotierten oder p-dotierten Poly-SiOₓ-Schicht (11,12) mit einer Dicke von > 10 nm auf der dielektrischen Schicht (15), wobei das Verhältnis der Dotierung von Poly-SiOₓ:kristallinem Si an der dielektrischen Sperrschicht > 2 ist, Bereitstellen mindestens einer dielektrischen Schicht (17) auf der Poly-SiOₓ-Schicht (11,12),
und Bereitstellen einer Metallschicht (18b) und/oder von Metallkontakten (18f) an einer Rück- und Vorderseite, die in elektrischem Kontakt mit der n-dotierten bzw. p-dotierten Poly-SiOₓ-Schicht (11,12) stehen, vorzugsweise
wobei die n-dotierte oder p-dotierte Poly-SiOₓ-Schicht (11,12) durch PECVD oder LPCVD hergestellt wird, wobei Dotierstoffe während der Abscheidung ständig zugeführt werden, vorzugsweise wobei Metallkontakte und/oder Metallschichten (18b,18f) durch Metallabscheidung und Abheben (von kontaktlosen Bereichen), Siebdruck und elektrische Beschichtung hergestellt werden, vorzugsweise
wobei Dotierstoffe in der Poly-SiOₓ-Schicht (11,12) aktiviert werden.

## Revendications

1. Cellule solaire à contact avant et arrière comprenant
au moins une hétérojonction,
des contacts avant et arrière (18b,18f), dans laquelle au moins un contact comprend un empilement de couches, lequel empilement comprend une couche de poly SiOₓ dopée n ou dopée p (11, 12) d'une épaisseur > 10 nm, une couche de Si cristallin dopée n ou dopée p (13,14) de 100 nm à 5000 nm d'épaisseur, dans laquelle la couche de poly SiOₓ (11,12) et la couche de Si cristallin (13,14) sont toutes deux dopées p ou sont toutes deux dopées n, et entre lesdites couches, une couche de barrière diélectrique (15) d'une épaisseur de 0<t_{diel}<2.5 nm, dans laquelle lesdites couches se recouvrent l'une l'autre, dans laquelle le rapport de dopage de poly Si-Oₓ:Si cristallin à la couche de barrière diélectrique est >2, de préférence >5, plus préférablement >10, encore plus préférablement >10².

2. Cellule solaire selon la revendication 1, dans laquelle la pile de contacts (18b,18f) est un contact de passivation sélective des porteurs, et/ou
dans laquelle la pile de contacts (18b,18f) est transparente.

3. Cellule solaire selon l'une quelconque des revendications 1 à 2, comprenant un substrat texturé simple face ou double face (10), et/ou
comprenant une couche (13,14) de Si cristallin dopée de type n ou p de 5*10¹⁴ à 0,5*10¹⁹ dopants/cm³, dans laquelle une concentration de dopage est de préférence spatialement constante,
dans laquelle les dopants de type n sont choisis parmi P, As, Bi, Sb et Li, et dans laquelle les dopants de type p sont choisis parmi B, Ga et In.

4. Cellule solaire selon l'une quelconque des revendications 1 à 3, comprenant une couche de passivation diélectrique ou un empilement de passivation diélectrique (17) sur la cellule, et/ou comprenant un substrat (10) dopé de type n ou p de 10¹⁴ à 10¹⁷ dopants/cm³.

5. Cellule solaire selon l'une quelconque des revendications 1 à 4, comprenant au moins l'un parmi une couche métallique sur une face arrière (18b), des contacts métalliques sur une face avant (18f) et/ou sur une face arrière (18b), et une couche conductrice transparente (19).

6. Cellule solaire selon l'une quelconque des revendications 1 à 5, comprenant au moins une couche de barrière diélectrique (15) ayant chacune indépendamment une épaisseur de 0,1 nm à 1,4 nm, dans laquelle la couche de barrière diélectrique (15) comprend indépendamment au moins un matériau choisi parmi SiO₂, HfO₂, et W₂O₅.

7. Cellule solaire selon l'une quelconque des revendications 1-6, dans laquelle le matériau de la couche conductrice transparente (19) est choisi parmi ITO, IOH, ZnO ou ZnO dopé, et IWO, et/ou dans lequel une épaisseur de la couche conductrice transparente (19) est <100 nm, et/ou dans lequel l'indice de réfraction est <2,2.

8. Cellule solaire selon l'une quelconque des revendications 1 à 7, dans laquelle, dans l'empilement de couches, la couche de poly SiOₓ dopée n ou dopée p (11,12), la couche de Si cristallin dopée n ou dopée p (13,14), et la couche de barrière diélectrique (15) sont chacune indépendamment en contact total l'une avec l'autre sur une zone de >50% d'une surface de la plus grande des deux surfaces de contact.

9. Cellule solaire selon l'une quelconque des revendications 1 à 8,
(A) comprenant un empilement d'une couche métallique (18b), d'une couche de poly-SiOₓ dopée de type n (12), d'une couche diélectrique (15), d'une couche de Si cristallin dopée de type n (14), d'un substrat en Si (10), d'une couche de Si cristallin dopée de type p (13), une couche diélectrique (15), une couche de poly-SiOₓ dopée de type p (11), une couche diélectrique (17), et des contacts métalliques (18f) pénétrant à travers la couche diélectrique (17) et entrant en contact avec la couche de poly-SiOₓ dopée de type p (11), ou
(B) comprenant un empilement d'une couche métallique (18b), d'une couche de poly-SiOₓ dopée de type p (12), d'une couche diélectrique (15), d'une couche de Si cristallin dopée de type p (14), d'un substrat en Si (10), d'une couche de Si cristallin dopée de type n (13), une couche diélectrique (15), une couche de poly-SiOₓ dopée de type n (11), une couche diélectrique (17), et des contacts métalliques (18f) pénétrant à travers la couche diélectrique (17) et entrant en contact avec la couche de poly-SiOₓ dopée de type n (11), ou
(C) comprenant un empilement d'une couche métallique (18b), d'une couche de poly-SiOₓ dopée de type n (12), d'une couche diélectrique (15), d'une couche de Si cristallin dopée de type n (14), d'un substrat en Si (10), d'une couche de Si cristallin dopée de type p (13), d'une couche diélectrique (15), une couche de poly-SiOₓ dopée de type p (11), une couche d'oxyde conductrice transparente (19), et des contacts métalliques (18f) pénétrant à travers la couche d'oxyde conductrice transparente (19) et entrant en contact avec la couche de poly-SiOₓ dopée de type p (11), ou
(D) comprenant un empilement d'une couche métallique (18b), d'une couche de poly-SiOₓ dopée de type p (12), d'une couche diélectrique (15), d'une couche de Si cristallin dopée de type p (14), d'un substrat en Si (10), d'une couche de Si cristallin dopée de type n (13), d'une couche diélectrique (15), une couche de poly-SiOₓ dopée de type n (11), une couche d'oxyde conductrice transparente (19), et des contacts métalliques (18f) pénétrant à travers la couche d'oxyde conductrice transparente (19) et entrant en contact avec la couche de poly-SiOₓ dopée de type n (11), ou
(E) comprenant un empilement d'une couche métallique (18b), d'une couche d'oxyde conductrice transparente (19), d'une couche de poly-SiOₓ dopée de type n (12), d'une couche diélectrique (15), d'une couche de Si cristallin dopée de type n (14), d'un substrat en Si (10), d'une couche de Si cristallin dopée de type p (13), une couche diélectrique (15), une couche de poly-SiOₓ dopée de type p (11), une couche d'oxyde conductrice transparente (19), et des contacts métalliques (18f) pénétrant à travers la couche d'oxyde conductrice transparente (19) et entrant en contact avec la couche de poly-SiOₓ dopée de type p (11), ou
(F) comprenant un empilement d'une couche métallique (18b), d'une couche d'oxyde conductrice transparente (19), d'une couche de poly-SiOₓ dopée de type p (12), d'une couche diélectrique (15), d'une couche de Si cristallin dopée de type p (14), d'un substrat en Si (10), d'une couche de Si cristallin dopée de type n (13), une couche diélectrique (15), une couche de poly-SiOₓ dopée de type n (11), une couche d'oxyde conductrice transparente (19), et des contacts métalliques (18f) pénétrant à travers la couche d'oxyde conductrice transparente (19) et entrant en contact avec la couche de poly-SiOₓ dopée de type n (11), ou
(G) comprenant un empilement d'une couche diélectrique (17), de contacts métalliques (18b) pénétrant à travers la couche diélectrique (17) et entrant en contact avec une couche de poly-SiOₓ dopée de type n (12), une couche de poly-SiOₓ dopée de type n (12), une couche diélectrique (15), une couche de Si cristallin dopée de type n (14), un substrat de Si (10), une couche de Si cristallin dopé de type p (13), une couche diélectrique (15), une couche de poly-SiOₓ dopé de type p (11), une couche diélectrique (17), et des contacts métalliques (18f) pénétrant à travers la couche diélectrique (17) et entrant en contact avec la couche de poly-SiOₓ dopé de type p (11), ou
(H) comprenant un empilement d'une couche diélectrique (17), de contacts métalliques (18b) pénétrant à travers la couche diélectrique (17) et entrant en contact avec une couche de poly-SiOₓ dopée de type p (12), une couche de poly-SiOₓ dopée de type p (12), une couche diélectrique (15), une couche de Si cristallin dopée de type p (14), un substrat en Si (10), une couche de Si cristallin dopé de type n (13), une couche diélectrique (15), une couche de poly-SiOₓ dopé de type n (11), une couche diélectrique (17), et des contacts métalliques (18f) pénétrant à travers la couche diélectrique (17) et entrant en contact avec la couche de poly-SiOₓ dopé de type n (11).

10. Cellule solaire selon l'une quelconque des revendications 1 à 9, comprenant au moins une surface texturée (20), dans laquelle la surface texturée (20) a un rapport d'aspect (hauteur:profondeur d'une structure texturée) de 2 à 10.

11. Cellule solaire selon l'une quelconque des revendications 1 à 10, ayant une couche de poly SiOₓ dopée n ou dopée p (11,12) indépendamment de 10 nm à 5000 nm d'épaisseur, et
comprenant 1*10¹⁹-5*10²² dopants de type n ou p/cm³, dans laquelle un profil de dopage est de préférence sensiblement constant sur l'épaisseur de la couche (11,12),
dans laquelle les dopants de type n sont choisis parmi P, As, Bi, Sb et Li,
où les dopants de type p sont choisis parmi B, Ga et In.

12. Cellule solaire selon l'une quelconque des revendications 1 à 11, comprenant au moins une couche diélectrique (17) ayant chacune indépendamment une épaisseur de 10 nm à 2000 nm,
dans laquelle la couche diélectrique (17) comprend indépendamment au moins un matériau choisi parmi SiNₓ, AlOₓ, un oxyde conducteur transparent dopé ou non dopé de type n ou p.

13. Cellule solaire selon l'une quelconque des revendications 1 à 12, dans laquelle le métal des couches métalliques (18b) et des contacts métalliques (18f) comprend indépendamment au moins un élément parmi Cu, Al, W, Ti, Ni, et
dans lequel l'épaisseur dudit métal (18b,18f) est de 200-5000 nm.

14. Procédé de production d'une cellule solaire selon l'une quelconque des revendications 1 à 13, comprenant au moins l'une des étapes consistant à
la fourniture d'un substrat de silicium (10),
la texturation d'une surface arrière et/ou avant du substrat (10) ,
le dopage d'une face avant (13,14),
le dopage d'une face arrière (13,14),
recuire lesdites faces dopées (13,14) à une température inférieure à 1000 °C pendant une période de temps suffisante, fournir une couche diélectrique (15) de 0<t_{diel}<2,5 nm d'épaisseur sur la face avant dopée et/ou la face arrière dopée,
fournir une couche de poly SiOₓ dopé n ou dopé p (11, 12) de >10 nm d'épaisseur sur la couche diélectrique (15), dans laquelle le rapport de dopage de poly SiOₓ:Si cristallin au niveau de la couche de barrière diélectrique est > 2,
fournir au moins une couche diélectrique (17) sur la couche de poly SiOₓ (11,12),
et la fourniture d'une couche métallique (18b) et/ou de contacts métalliques (18f) sur un côté arrière et un côté avant en contact électrique avec la couche de poly SiOₓ dopée n ou dopée p (11, 12), respectivement, de préférence
dans lequel la couche de poly SiOₓ dopée n ou dopée p (11, 12) est fournie par PECVD ou LPCVD, dans lequel des dopants sont constamment fournis pendant le dépôt, de préférence dans lequel les contacts métalliques et/ou les couches métalliques (18b,18f) sont fournis par dépôt de métal et décollage (des zones sans contact), sérigraphie et placage électrique, de préférence
dans lequel les dopants dans la couche de poly SiOₓ (11,12) sont activés.
